# EUROPEAN PATENT APPLICATION

(11) **EP 4 814 654 A1**
(43) Date of publication of application: **30.09.2026**
(21) Application number: 25218009.6
(22) Date of filing: 24.11.2025
(51) Int. Cl.: G06F 1/183

(54) **METHODS AND APPARATUS TO INCREASE NUMBER OF DIMMS PER SOCKET AND/OR ENHANCE COOLING OF DIMMS**

(30) Priority: 28.03.2025 US 202519094292
(71) Applicant: Intel Corporation, Santa Clara, CA 95054 (US)
(72) Inventor: SHAH, Dhruvalkumar, Hillsboro, 97124 (US); SAHA, Sanjoy, Portland, 97229 (US); MILOBINSKI, Marc, Scappoose, 97056 (US)
(74) Representative: Maiwald GmbH

(57) **Abstract**

Systems, apparatus, articles of manufacture, and methods to increase number of DIMMs per socket and/or enhance cooling of DIMMs are disclosed. An example apparatus includes a circuit board including a first end, a second end opposite the first end, a first lateral edge, and a second lateral edge opposite the first lateral edge. The example apparatus includes a first bank of memory slots to extend between the first and second ends of the circuit board. The first bank of memory slots is a first distance from the first end. The example apparatus also includes a second bank of memory slots to extend between the first and second ends of the circuit board. The second bank of memory slots is a second distance from the first end. The second distance is greater than the first distance.

## Description

### BACKGROUND

With the rise of "big data" applications, artificial intelligence (AI) applications, and other high performance and/or centralized computing (e.g., "cloud computing") applications, processor chips are being pushed to higher and higher levels of performance. Furthermore, there is an ever increasing demand for more memory capacity to operate in conjunction with higher performance processor chips. Efforts to meet increasing memory demands include improving the performance and/or density of transistors on a given memory chip and/or implementing systems that include a greater number of memory chips.

### BRIEF DESCRIPTION OF THE DRAWINGS

FIG. 1 is a perspective view of an example server assembly constructed in accordance with teachings disclosed herein.
FIG. 2 is a top view of the example server assembly of FIG. 1.
FIG. 3 shows tabulated results of an analysis of cooling capabilities for the DIMMs shown in FIGS. 1 and 2 based on a first spacing of the DIMMs.
FIG. 4 shows tabulated results of an analysis of cooling capabilities for the DIMMs shown in FIGS. 1 and 2 based on a second spacing of the DIMMs.
FIG. 5 is a perspective view of another example server assembly constructed in accordance with teachings disclosed herein.
FIG. 6 is a top view of the example server assembly of FIG. 5.
FIG. 7 is a perspective view of another example server assembly constructed in accordance with teachings disclosed herein.
FIG. 8 is a top view of the example server assembly of FIG. 7.
FIG. 9 shows tabulated results of an analysis of power consumption for DIMMs with different capacities that may be used in the example server assembly of FIGS. 7 and 8.

In general, the same reference numbers will be used throughout the drawing(s) and accompanying written description to refer to the same or like parts. The figures are not necessarily to scale.

### DETAILED DESCRIPTION

With the explosive growth in demand for AI, machine learning, large language models, and/or other types of high performance computing applications, there is a need to process large amounts of data in very short amounts of time. Such high performance computing systems need increased memory capacity that can operate at high speeds. Such needs are driven by various factors including (a) increases in core count in processor chips that can manage a greater number of processing tasks in parallel, (b) data-intensive workloads, and (c) emerging technologies such as multi-capacity rank dual in-line memory module (MRDIMM) and double data rate-5 (DDR5) technologies that offer high data transfer rates.

The number of dual in-line memory modules (DIMMs) that can be associated with a given processor socket on a server is limited by the number of memory channels, the number of memory controllers, the physical space available on the server motherboard, the amount of power to be used and the associated thermal dissipation of such power consumption, and performance tradeoffs. For example, advancement in the performance of processor chips (e.g., CPU packages) often results in larger chips that take up more space on a server. Furthermore, advancement in the performance of processor chips is often associated with the need for greater memory capacity. In other words, advancements in processor performance create a need to fit more DIMMs on a server than in the past and to do so in less space than has been available in the past. In examples disclosed herein this is achieved by using multiple (e.g., two) DIMMs per channel with different DIMMs in separate memory banks that are positioned end-to-end relative to one another rather than all DIMMs being positioned side-by-side as has been done in the past.

Positioning DIMMs end-to-end on a server as disclosed herein creates challenges for thermal cooling because some DIMMs will be upstream of other DIMMs in a direction of flow of cooling air. Accordingly, as the cooled air passes the upstream DIMMs, the air will heat up as it draws away heat from these DIMMs, thereby having a reduced ability to cool (or draw away heat from) the downstream DIMMs. Examples disclosed herein overcome these challenges. In some examples, the downstream DIMMs are placed wider apart (e.g., at a greater pitch). The increased space between the DIMMs permits greater airflow to enhance cooling in a way that compensates for the warmer temperature of air. In some examples, DIMMs can be binned between higher capacity (e.g., higher power) and lower capacity (e.g., lower power) and positioned at either an upstream location or a downstream location accordingly. More particularly, in some examples, higher capacity DIMMs are positioned in an upstream memory bank and lower capacity DIMMs are positioned in a downstream memory bank. The higher capacity DIMMs are positioned in the upstream position because they produce more heat and so are cooled more efficiently based on being directly exposed to fresh incoming cooled air. By contrast, the lower capacity DIMMs produce less heat and so can be adequately cooled by air that has already passed by the upstream DIMMs. In some examples, both solutions disclosed herein can be used in combination. That is, in some examples, higher capacity DIMMs are spaced apart by a first (narrower) pitch in an upstream memory bank while lower capacity DIMMs are spaced apart by a second (wider) pitch in a downstream memory bank. Further, other positions and/or arrangements of DIMMs are also possible to fit more DIMMs on a server while still providing efficient cooling of all such DIMMs.

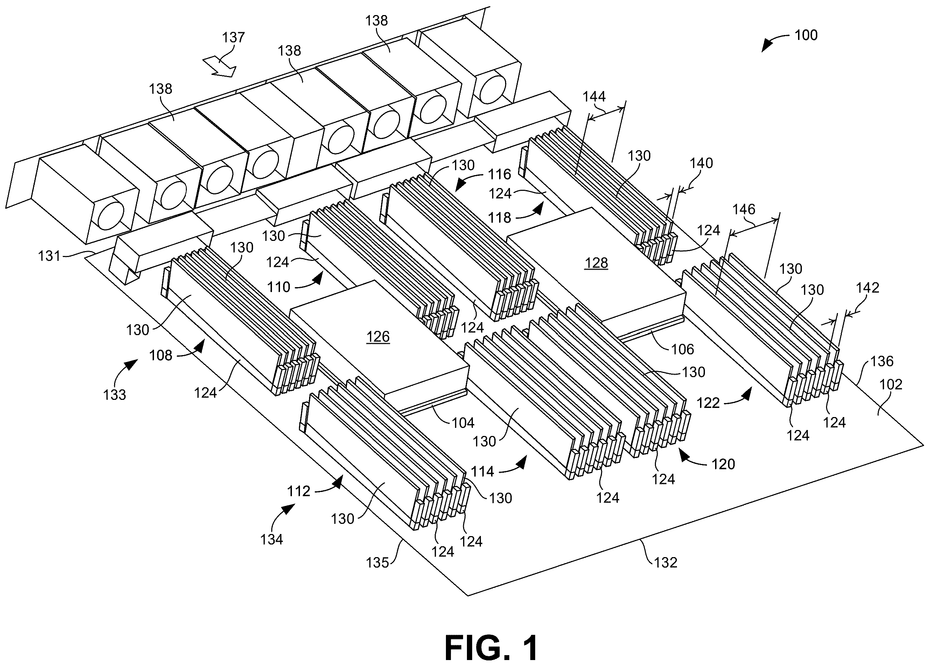

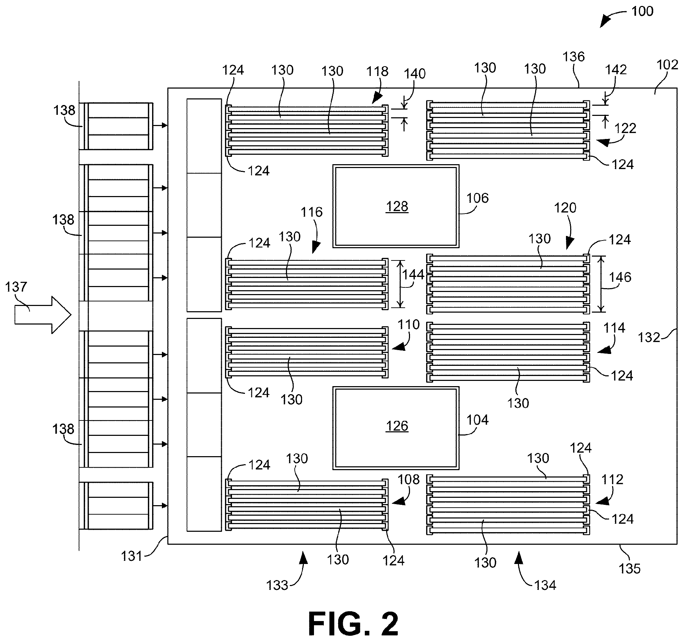

FIG. 1 is a perspective view of an example server assembly 100 constructed in accordance with teachings disclosed herein. FIG. 2 is a top view of the example server assembly 100 of FIG. 1. In this example, the server assembly 100 includes a motherboard 102 (e.g., a server board, a main printed circuit board) that includes two processor sockets (e.g., a first processor socket 104 and a second processor socket 106) and eight different memory banks or DIMM banks (e.g., a first memory bank 108, a second memory bank 110, a third memory bank 112, a fourth memory bank 114, a fifth memory bank 116, a sixth memory bank 118, a seventh memory bank 120, an eighth memory bank 122) of DIMM slots 124 (e.g., memory slots, DIMM sockets).

As represented in the illustrated example of FIGS. 1 and 2, each of the processor sockets 104, 106 includes a corresponding processor chip 126, 128 (e.g., processor die, integrated circuit (IC) package, CPU package, etc.) inserted therein. In some examples, the server assembly 100 includes only one processor socket to receive one processor chip. In other examples, the server assembly can include more than two processor sockets to receive a corresponding number of processor chips. Further, in this example, each of the DIMM slots 124 includes a corresponding DIMM 130 (e.g., memory card, memory stick, memory board, etc.) inserted therein. In this example, each of the memory banks 108, 110, 112, 114, 116, 118, 120, 122 includes multiple DIMM slots 124 to hold an array of DIMMs 130. More particularly, in this example, each memory bank 108, 110, 112, 114, 116, 118, 120, 122 includes six DIMM slots 124 to hold up to six DIMMs 130. In other examples, the memory banks 108, 110, 112, 114, 116, 118, 120, 122 can have any other suitable number of DIMM slots 124 greater or less than six. In this example, the first, second, third, and fourth memory banks 108, 110, 112, 114 are communicatively (e.g., electrically) coupled with the first processor socket 104 and the fifth, sixth, seventh, and eighth memory banks 116, 118, 120, 122 are communicatively coupled with the second processor socket 106. Thus, in the illustrated example, each of the processor chips 126, 128 is communicatively coupled to a total of twenty-four different DIMMs 130. In some examples, the processor chips 126, 128 are positioned at or near a central location between the associated memory banks 108, 110, 112, 114, 116, 118, 120, 122 so that each memory bank is approximately the same distance away from the corresponding processor chip 126, 128. Such an arrangement serves to reduce speed and/or signal integrity issues arising from communications between the processor chips 126, 128 and the DIMMs 130 in the memory banks 108, 110, 112, 114, 116, 118, 120, 122.

The twenty-four DIMMs 130 provided for each of the processor chips 126, 128 is a significant increase in memory capacity relative to many known servers that provide access up to twelve or, at most, sixteen DIMMs. This significant increase in the number of DIMMs 130 (and, thus, the increased memory capacity) is made possible by arranging the memory banks 108, 110, 112, 114, 116, 118, 120, 122 (and the associated DIMMs 130) end-to-end between a first end 131 (e.g., a front end) and a second end 132 (e.g., a rear end, a back end) of the motherboard 102. More particularly, as shown in the illustrated example, an elongate length of the first memory bank 108 is positioned longitudinally in alignment with an elongate length of the third memory bank 112, an elongate length of the second memory bank 110 is positioned longitudinally in alignment with an elongate length of the fourth memory bank 114, an elongate length of the fifth memory bank 116 is positioned longitudinally in alignment with an elongate length of the seventh memory bank 120, and an elongate length of the sixth memory bank 118 is positioned longitudinally in alignment with an elongate length of the eighth memory bank 122. In other words, the memory banks 108, 110, 112, 114, 116, 118, 120, 122 holding the DIMMs 130 are arranged in two rows 133, 134 with the first row a first distance from the first end 131 and the second row 134 a second distance from the first end 131 that is greater than the first distance. In some examples, the memory banks 108, 110, 112, 114, 116, 118, 120, 122 are arranged into more than two rows. By contrast, known servers include only a single row of DIMMs that are typically laterally aligned with associated processor sockets between opposing lateral edges (e.g., a first lateral edge 135 and a second lateral edge 136) of the motherboard 102.

In some examples, the memory banks 108, 110, 112, 114, 116, 118, 120, 122 in both rows 133, 134 are oriented so that the associated DIMM slots 124 and the DIMMs 130 inserted therein are substantially parallel to one another. As used herein, substantially parallel means within 5 degrees of exactly parallel. In some examples, the memory banks 108, 110, 112, 114, 116, 118, 120, 122, the associated DIMM slots 124, and the DIMMs 130 are also oriented substantially parallel the lateral edges 135, 136 of the motherboard 102. That is, the memory banks 108, 110, 112, 114, 116, 118, 120, 122, the associated DIMM slots 124, and the DIMMs 130 longitudinally extend between the first and second ends 131, 132 of the motherboard 102. In some examples, this orientation also corresponds to a direction 137 of airflow of cooled air. Positioning the DIMMS 130 to be substantially parallel to the direction 137 of airflow enables cooled air to pass across and/or between the DIMMs 130 for enhanced cooling. In some examples, the cooled air is blown in the direction 137 aligned with the DIMMs 130 by one or more fans 138. In this example, eight fans 138 are included. In other examples, a different number of fans 138 greater or less than eight can be used.

Inasmuch as the memory banks 108, 110, 112, 114, 116, 118, 120, 122 are arranged end-to-end and oriented to be substantially parallel to the direction 137 of airflow in the illustrated example of FIGS. 1 and 2, the memory banks 108, 110, 116, 118 in the first row 133 are directly upstream of the memory banks 112, 114, 120, 122 in the second row 134. This arrangement serves to provide a clear path for the incoming cooled air to be blown across the processor chips 126, 128 without any upstream obstructions for improved (e.g., optimal) cooling of the processor chips 126, 128. However, this arrangement results in the cooled air passing by and/or through the upstream DIMMs (e.g., the DIMMs 130 in the first row 133 of the memory banks 108, 110, 116, 118) before reaching the downstream DIMMs (e.g., the DIMMs 130 in the second row 134 of the memory banks 112, 114, 120, 122). That is, the DIMMs 130 in the second row 134 of the memory banks 112, 114, 120, 122 are shadowed by the DIMMs 130 in the first row 133 of the memory banks 108, 110, 116, 118 with respect to the direction 137 of airflow of the cooled air. The upstream DIMMs 130 are also referred to herein as front DIMMs whereas the downstream DIMMs 130 are referred to herein as rear DIMMs.

Similar to the processor chips 126, 128, in this example, the upstream DIMMs 130 in the first row 133 are cooled by freshly incoming air that is unobstructed by any upstream components. However, unlike these DIMMs 130 in the first row 133 and the processor chips 126, 128, the downstream DIMMs 130 in the second row 134 are not provided with an unobstructed path for the air. Instead, the air first passes across and/or through the upstream DIMMs 130 in the first row 133. As the fresh incoming cooled air passes the DIMMs 130 in the first row 133, the air will increase in temperature as it draws away heat from the DIMMs 130. While this serves to dissipate heat from the first row 133 of DIMMs 130, the increased temperature of the air downstream of such DIMMs 130 will result in less efficient cooling of the further downstream DIMMs (e.g., the DIMMs 130 in the second row 134). However, as shown in the illustrated example, the reduced cooling efficiency arising from the increased temperature of the air that interacts with the downstream DIMMs 130 is compensated for by increasing the spacing between adjacent ones of the DIMMs 130 for increased air flow to enhance cooling efficiency. Specifically, as shown in the illustrated example, the upstream DIMMs 130 in the first (upstream) row 133 are separated at a first pitch 140 (spaced along a line extending between the lateral edges 135, 136 of the motherboard 102) that is smaller than a second pitch 142 for the DIMMs 130 in the second (downstream) row 134. As a result of these different pitches 140, 142, an overall width 144 of the upstream memory banks 108, 110, 116, 118 is less than (narrower than) an overall width 146 of the downstream memory banks 112, 114, 120, 122.

Experimental simulations of the arrangement of DIMMs 130 shown in the example server assembly 100 of FIGS. 1 and 2 show that adequate cooling can be achieved for both the upstream and downstream DIMMs 130. More particularly, the case-to-ambient thermal resistant (*Ψ*) (e.g., a measure of ability to transfer heat from a case of a device (e.g., memory chips on the DIMMs 130) to the surrounding air) was calculated for different DIMM pitches as a function of airflow approach velocity (V) based on the following equation: $Ψ = a + {bV}^{- g}$ where *a*, *b,* and g are constants calculated from fluid flow simulation analysis. Table 1 provides calculated values for these constants for several different DIMM pitches.

**Table 1: Values for constants a, b, g in Equation 1**

| DIMM Pitch (inch) | a | b | g |
|---|---|---|---|
| 0.35 | 0 | 6.5808 | 0.777053 |
| 0.32 | 0 | 6.301948 | 0.777053 |
| 0.29 | 0 | 5.9564 | 0.78 |
| 0.25 | 0 | 5.7307 | 0.792 |

The case-to-ambient thermal resistance can also be expressed in terms of the case temperature (Tcase) corresponding to the temperature of a DIMM (e.g., temperature of the memory chips on the DIMM), the ambient temperature (Tambient) of the surrounding air, and the power consumption of the DIMM as follows: $Ψ = \left(Tcase-Tambient\right) / Power$ Based on the constants provided in Table 1 and a given dynamic random-access memory (DRAM) specification of 83°C and local ambient temperature in front of a server, the cooling capabilities for different DIMM pitches was estimated using equation 2. More particularly, multiple simulations were conducted starting with the same DIMM pitch for both upstream and downstream DIMMs of 0.32 inches (e.g., the first pitch 140 = the second pitch 142 = 0.32 inches) and then gradually reducing the pitch of the upstream DIMMs until the cooling capability of both the upstream and downstream DIMMs was approximately the same for improved (e.g., optimal) dissipation of heat.

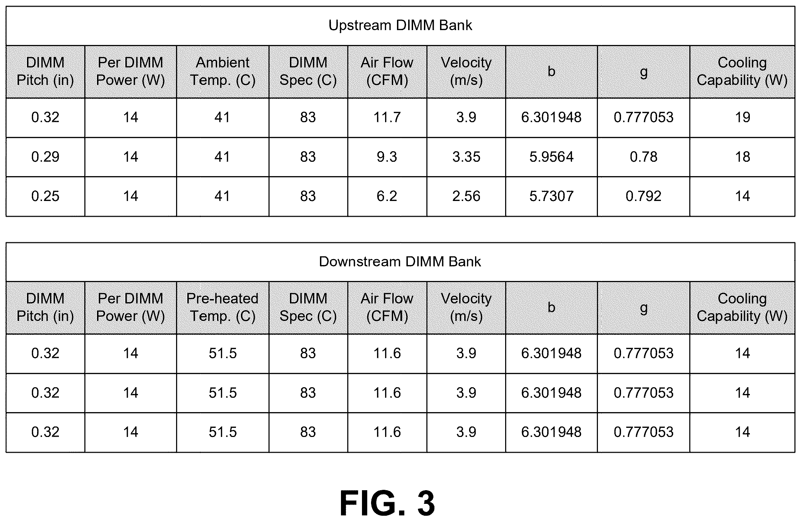

FIG. 3 provides tabulated results of the analysis and the associated cooling capability for the upstream (front) DIMMs and the downstream (rear) DIMMs. As shown in FIG. 3, the upper table corresponds to the upstream DIMMs with each row having a different pitch and resulting different air flow and associated different velocity. By contrast, the lower table in FIG. 3 corresponds to the downstream DIMMs that are fixed at the same pitch in each row and, thus, associated with the same air flow and associated velocity in each row. Each of the three rows in the lower table in FIG. 3 reflects the results associated with the corresponding row in the upper table in FIG. 3. Notably, in this example, the upstream DIMMs are cooled by air at an ambient temperature of 41°C as shown in the upper table. By contrast, the downstream DIMMs are cooled by air at a higher "pre-heated" temperature due to the air having passed by and drawn heat away from the upstream DIMMs. Thus, in this example, the downstream DIMMs are cooled by air at 51.5°C. As shown, when both rows 133, 134 of DIMMs 130 are at a pitch of 0.32 inches, the cooling capability of the air blown across the upstream DIMMs is 19 W, whereas the cooling capability of the pre-heated air blown across the downstream DIMMs is only 14 W. However, when the pitch of the upstream DIMMs (e.g., the first pitch 140) is reduced to 0.25 inches, the cooling capability reduces to 15 W, which is relatively close to the 14W of cooling capability associated with the downstream DIMMs. Having similar cooling capabilities for all DIMMs 130 (both the upstream and downstream DIMMs) is beneficial when all the DIMMs 130 are the same type of memory that consume the same power (e.g., have the same thermal design power (TDP)). Accordingly, in some examples, the spacing of the upstream DIMMs 130 relative to the downstream DIMMs 130 is configured so that all of the DIMMs 130 have approximately the same cooling capacity for a given airflow input or at least are within a threshold difference of one another. In some examples, the threshold difference is less than or equal to 2 W. In some examples, the threshold difference in cooling capacity of the air flow between upstream and downstream DIMMs is greater than 2 W.

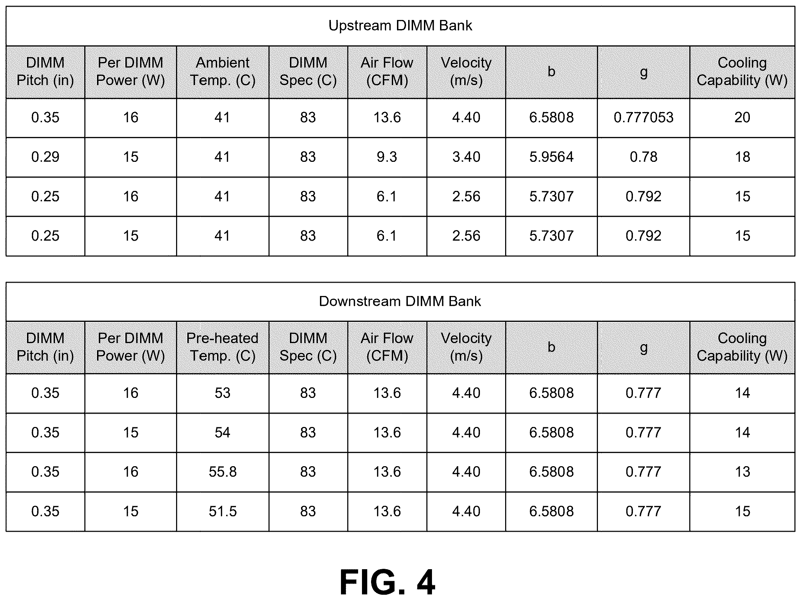

FIG. 4 provides tabulated results of another analysis of the cooling capabilities for the DIMMs 130 on the server assembly 100 of FIG. 1 starting at a different pitch. Specifically, in this example, the downstream DIMMs 130 are spaced at a pitch of 0.35 inches. As shown by the bottom row in both tables of FIG. 4, a cooling capability of approximately 15 W can be achieved for both the upstream and downstream DIMMs when they are spaced apart at pitches of 0.25 inches and 0.35 inches, respectively. The results shown in FIGS. 3 and 4 are merely representative and different values are possible under different circumstances. For instance, higher cooling capabilities can be achieved by selecting stronger fans and/or incorporating air baffling solutions to enhance (e.g., optimize) the air flow.

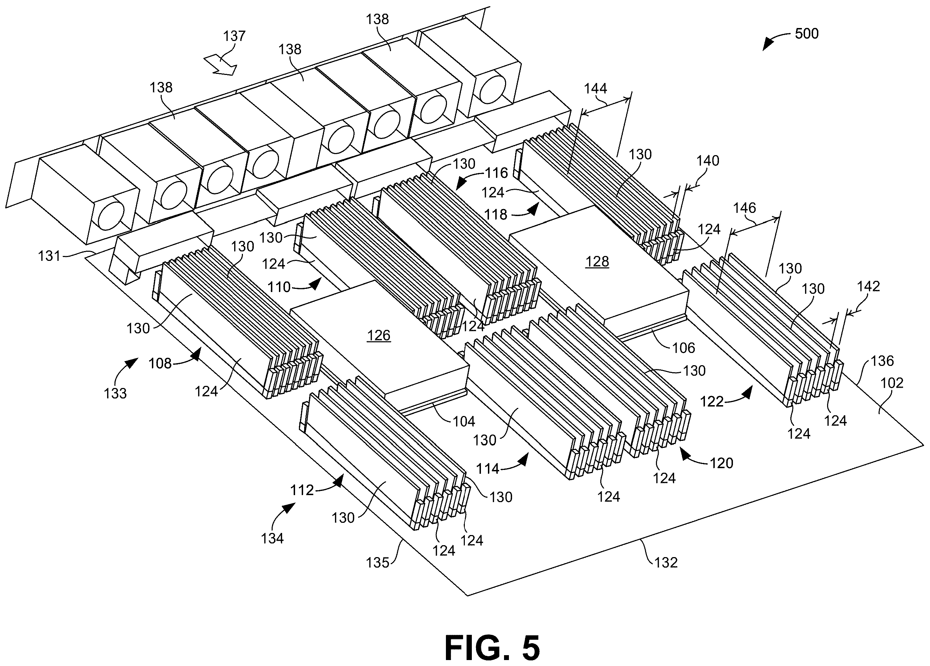

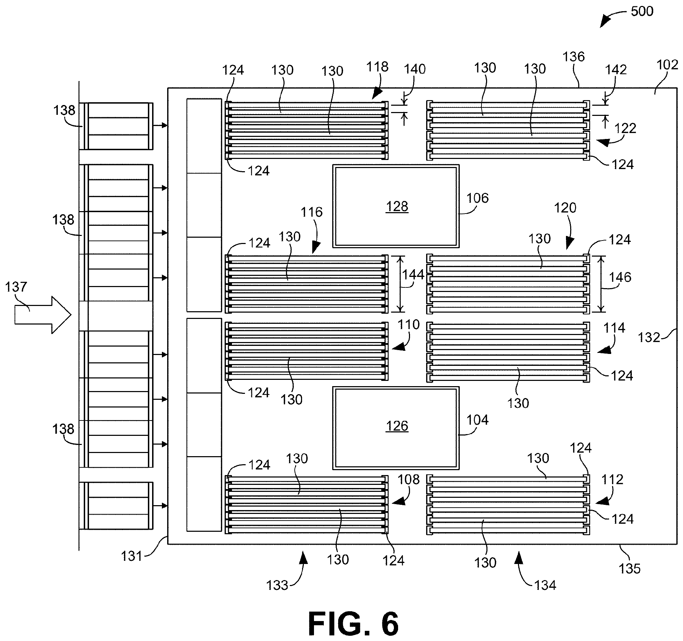

FIG. 5 is a perspective view of another example server assembly 500 constructed in accordance with teachings disclosed herein. FIG. 6 is a top view of the example server assembly 500 of FIG. 5. The example server assembly 500 of FIGS. 5 and 6 is substantially the same as the example server assembly 100 of FIGS. 1 and 2 except as noted below and otherwise made clear from the context. Accordingly, the same reference numbers are used in FIGS. 5 and 6 to identify the same or similar features as shown in FIGS. 1 and 2 and the description of such features provided above applies equally to the corresponding features of FIGS. 5 and 6.

Similar to FIGS. 1 and 2, the memory banks 108, 110, 116, 118 in the first row 133 in the illustrated example of FIGS. 5 and 6 include DIMMs 130 (e.g., upstream DIMMs) that are spaced at a first pitch 140 that is less than a second pitch 142 associated with DIMMs 130 in the memory banks 112, 114, 120, 122 in the second row 134 (e.g., downstream DIMMs). However, the example of FIGS. 5 and 6 differs from the example of FIGS. 1 and 2 in the number of DIMMs 130 in the memory banks 108, 110, 116, 118 in the first row 133. Specifically, in FIGS. 5 and 6, each of the memory banks 108, 110, 116, 118 in the first row 133 includes eight DIMM slots 124 to hold eight DIMMs 130 as compared with the six DIMM slots 124 in the memory banks 112, 114, 120, 122 in the second row 134. In other examples, a different number of DIMMs 130 are included in the upstream memory banks 108, 110, 116, 118.

In the illustrated example of FIGS. 5 and 6, more DIMMs 130 are included in the upstream memory banks 108, 110, 116, 118 than the downstream memory banks 112, 114, 120, 122 because more DIMMs can fit within the available space due to the smaller pitch 140. That is, unlike what is shown in FIGS. 1 and 2, in the illustrated example of FIGS. 5 and 6, the overall widths 144, 146 of both the upstream and downstream memory banks 108, 110, 112, 114, 116, 118, 120, 122 are approximately the same despite the different pitches 140, 142 due to the higher number of DIMMs 130 in the upstream memory banks.

Although the overall widths 144, 146 of the upstream and downstream memory banks 108, 110, 112, 114, 116, 118, 120, 122 are shown as substantially the same in FIGS. 5 and 6, this need not be the case. In some examples, the first width 144 can be greater than or less than the second width 146 depending on the number of DIMMs 130 included in the different memory banks 108, 110, 112, 114, 116, 118, 120, 122 and the associated pitches 140, 142 of the DIMMs 130. In connection with this, in some examples, the upstream memory banks 108, 110, 116, 118 include fewer DIMMs 130 than in the downstream memory banks 112, 114, 120, 122 (rather than more as in FIGS. 5 and 6). In such examples (with fewer DIMMs 130 spaced at a smaller pitch 140), the overall width 144 of the upstream memory banks 108, 110, 116, 118 is significantly less than the overall width 146 of the downstream memory banks 112, 114, 120, 122 (e.g., even less than shown in the illustrated example of FIGS. 1 and 2 in which the number of upstream and downstream DIMMs is the same).

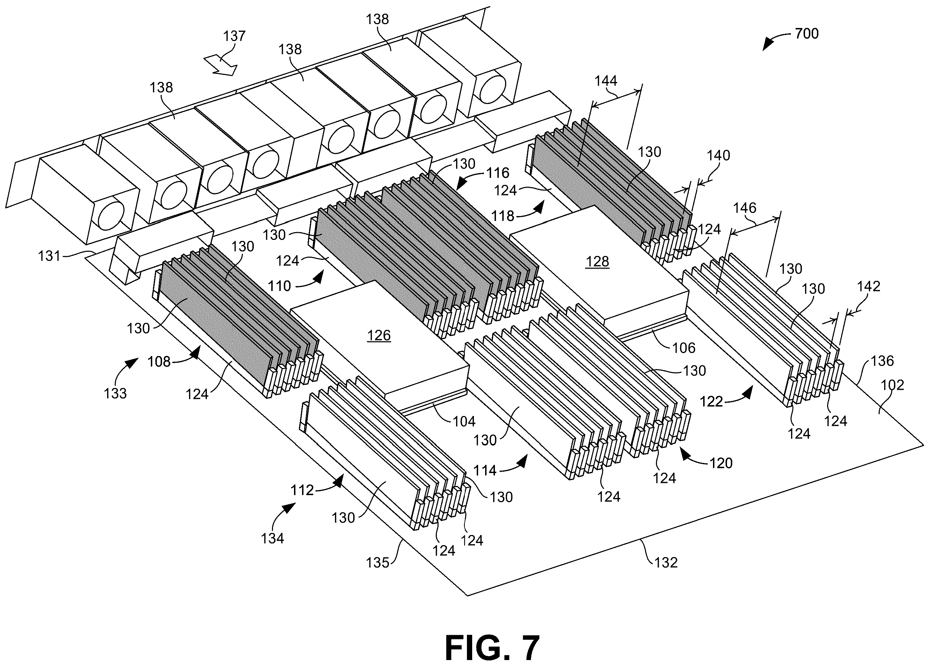

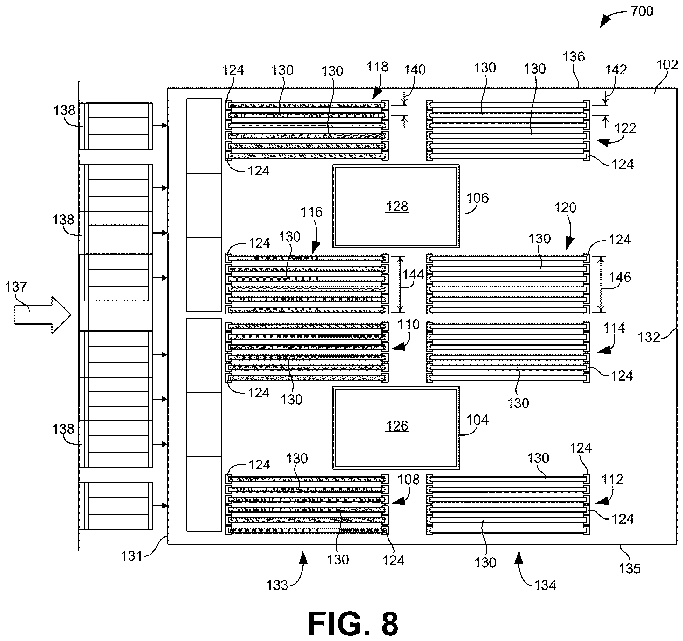

FIG. 7 is a perspective view of another example server assembly 700 constructed in accordance with teachings disclosed herein. FIG. 8 is a top view of the example server assembly 700 of FIG. 7. The example server assembly 700 of FIGS. 7 and 8 is substantially the same as the example server assembly 100 of FIGS. 1 and 2 except as noted below and otherwise made clear from the context. Accordingly, the same reference numbers are used in FIGS. 7 and 8 to identify the same or similar features as shown in FIGS. 1 and 2 and the description of such features provided above applies equally to the corresponding features of FIGS. 7 and 8.

In illustrated example of FIGS. 7 and 8, the number of DIMMs 130 in each of the memory banks 108, 110, 112, 114, 116, 118, 120, 122 is the same as in FIGS. 1 and 2 (e.g., each memory bank includes six DIMMs). However, unlike the example shown in FIGS. 1 and 2, the DIMMs 130 in FIGS. 7 and 8 are spaced at the same pitch in all eight memory banks 108, 110, 112, 114, 116, 118, 120, 122. That is, in the illustrated example of FIGS. 7 and 8, the first pitch 140 for the DIMMs 130 in the first (upstream) row 133 is the same as the second pitch 142 for the DIMMs 130 in the second (downstream) row 134. In other words, the arrangement of DIMMs 130 in the example shown in FIGS. 7 and 8 differs from the example shown in FIGS. 1 and 2 in that the DIMMs 130 in the first row 133 in FIGS. 7 and 8 are spaced farther apart. Additionally, the example of FIGS. 7 and 8 differs from the example of FIGS. 1 and 2 based on the capacity of DIMMs 130 inserted in the DIMM slots 124 in the first row 133 relative to the capacity of the DIMMs 130 inserted into the DIMM slots 124 in the second row 134. More particularly, in this example, the upstream DIMMs 130 are higher capacity DIMMs 130 than the downstream DIMMs 130. In FIGS. 7 and 8, the different capacities of the different DIMMs 130 is represented by the different shading of the DIMMs 130 with a darker shading representing a higher capacity.

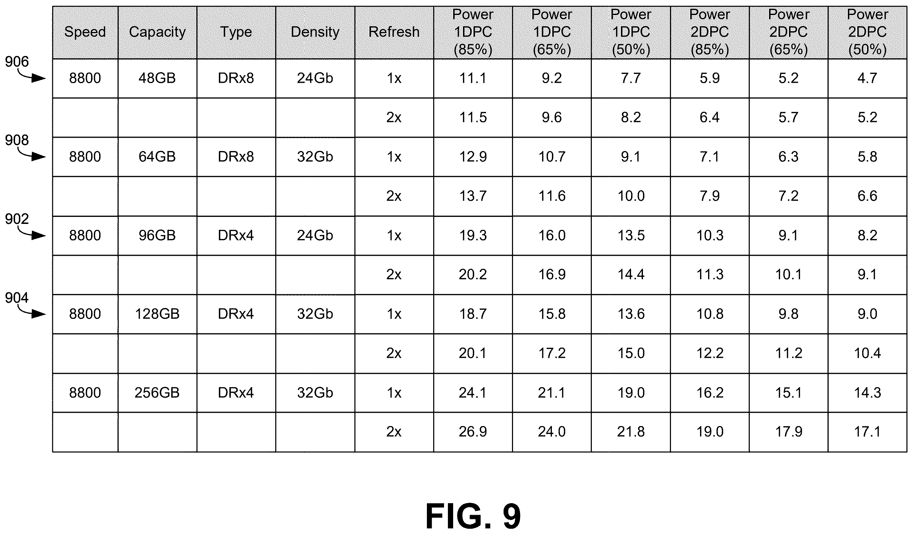

Inasmuch as the darker shaded DIMMs 130 (e.g., the upstream DIMMs) in the first row 133 of memory banks 108, 110, 116, 118 have a higher capacity, such DIMMs 130 are associated with higher power consumption and, thus, generate more heat than the lower capacity DIMMs 130 (e.g., the lighter shaded downstream DIMMs). The wider spacing of the upstream DIMMs 130 in FIGS. 7 and 8 (as compared to the smaller first pitch 140 shown in FIGS. 1 and 2) provides for increased airflow across and/or between the DIMMs 130 to compensate for the additional heat produced by the higher capacity (higher power) nature of the DIMMs 130. As a result, both the upstream (front) and downstream (rear) DIMMs 130 are associated with similar cooling capacities. FIG. 9 provides tabulated results of an analysis of power consumption for DIMMs with different capacities (e.g., 48 gigabytes (GB), 64GB, 96GB, 128GB, 256GB) for both one DIMM per channel (1DPC) and two DIMMs per channel (2DPC) arrangements. Notably, in this example, the different DIMMs represented in FIG. 9 all operate at the same speed because the different DIMMs are to be communicatively coupled to the same processor chip (e.g., one of the processor chips 126, 128).

As shown in the table of FIG. 9, different capacity DIMMs can be selected with relatively similar power consumptions to be used in the example server assembly 700 of FIGS. 7 and 8 with the higher power DIMMs (e.g., the higher capacity DIMMs) placed in the first (upstream) row 133 and the lower power DIMMs (e.g., the lower capacity DIMMs) placed in the second (downstream) row 134. For example, the power consumption values in the fifth row 902 in the table of FIG. 9 (associated with a DIMM having a 96GB capacity) and the seventh row 904 in the table of FIG. 9 (associated with a DIMM having a 128GB capacity) are all relatively close (e.g., within 1 W of each other). Accordingly, these DIMMs could be used together with the higher capacity DIMMs (e.g., with a 128GB capacity) placed upstream of the lower capacity DIMMs (e.g., with a 96GB capacity). Similarly, the DIMMs represented in the first row 906 and the third row 908 are sufficiently similar (e.g., power consumption values within 2 W of each other) to be used together with the higher (64GB) capacity DIMM positioned upstream of the lower (48GB) capacity.

In some examples, the different capacity DIMMs 130 shown in FIGS. 7 and 8 can be used in combination with the different pitches 140, 142 of DIMMs 130 as shown and described in FIGS. 1 and 2 and/or the different numbers of DIMMs 130 as shown and described in FIGS. 5 and 6. That is, in some examples, the upstream DIMMs 130 can have a higher capacity than the downstream DIMMs 130 and also be spaced at a first pitch 140 that is different from (e.g., smaller than) the second pitch 142 associated within the downstream DIMMs 130. In some examples, depending on the amount of difference in capacity between the upstream and downstream DIMMs 130, the first pitch 140 can be greater than the second pitch 142 to facilitate the cooling of the upstream DIMMs 130. Further, in some examples, higher capacity DIMMs can be placed downstream of lower capacity DIMMs (e.g., reversed relative to what is shown in FIGS. 8 and 9). In such examples, the second pitch 142 of the downstream DIMMs 130 (e.g., the higher capacity DIMMs) is significantly greater than the first pitch 140 of the upstream DIMMs 130 to enhance the cooling capacity of the blown air sufficiently to compensate for both the higher power consumption of the downstream (higher capacity) DIMMs and the increased temperature of air used to cool such (based on the air being pre-heated by crossing over and/or through the upstream (lower capacity) DIMMs).

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

As used herein "substantially real time" refers to occurrence in a near instantaneous manner recognizing there may be real world delays for computing time, transmission, etc. Thus, unless otherwise specified, "substantially real time" refers to real time + 1 second.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, apparatus, articles of manufacture, and methods have been disclosed that enable an increased number of DIMMs on a server while still providing adequately cooling of such DIMMs. The increased number of DIMMs is achieved by arranging the DIMMs end-to-end with a first set of DIMMs being towards the front of the server with a second set of DIMMs behind the first set. In some examples, the different sets of DIMMS are arranged in alignment with the direction of airflow of cooled air used to cool the DIMMs. Thus, the first set of DIMMs are upstream of the second set of DIMMs. Due to this arrangement, the air the interfaces with the second (downstream) set of DIMMs (the downstream DIMMs) will be warmer than when the air initially interfaces with the first (upstream) set of DIMMs. In some disclosed examples, this change in air temperature is compensated for by adjusting the pitch or spacing of the downstream DIMMs relative to the upstream DIMMs so that all the DIMMs are adequately cooled. Additionally or alternatively, in some examples, the DIMMs can be binned and arranged according to their capacity with higher capacity DIMMs positioned upstream where the cooler air temperature is relied on for cooling while lower capacity DIMMs can be adequately cooled with air that has been warmed by passing the higher capacity DIMMs. Disclosed systems, apparatus, articles of manufacture, and methods are accordingly directed to one or more improvement(s) in the operation of a machine such as a computer or other electronic and/or mechanical device.

Further examples and combinations thereof include the following:
Example 1 includes an apparatus comprising a circuit board including a first end, a second end opposite the first end, a first lateral edge, and a second lateral edge opposite the first lateral edge, a first bank of memory slots to extend between the first and second ends of the circuit board, the first bank of memory slots a first distance from the first end, the first bank of memory slots to receive first memory boards, and a second bank of memory slots to extend between the first and second ends of the circuit board, the second bank of memory slots a second distance from the first end, the second bank of memory slots to receive second memory boards, the second distance greater than the first distance.
Example 2 includes any preceding clause(s) of example 1, wherein the first and second banks of memory slots are in longitudinal alignment along a line extending between the first and second ends of the circuit board, the first bank of memory slots between the first end of the circuit board and the second bank of memory slots.
Example 3 includes any preceding clause(s) of any one or more of examples 1-2, including a socket to receive a processor chip, the socket electrically coupled to both the first and second banks of memory slots via the circuit board, both the first and second banks of memory slots closer to the first lateral edge of the circuit board than the socket is to the first lateral edge of the circuit board.
Example 4 includes any preceding clause(s) of any one or more of examples 1-3, including a third bank of memory slots electrically coupled to the socket, the third bank of memory slots the first distance from the first end of the circuit board, the socket between the first and third banks of memory slots, and a fourth bank of memory slots electrically coupled to the socket, the fourth bank of memory slots the second distance from the first end of the circuit board, the socket between the first and third banks of memory slots.
Example 5 includes any preceding clause(s) of any one or more of examples 1-4, wherein the socket is a first socket, the apparatus including a second socket to receive a second processor chip, and additional banks of memory slots electrically coupled to the second socket.
Example 6 includes any preceding clause(s) of any one or more of examples 1-5, wherein the first bank of memory slots is structured to space the first memory boards by a first pitch and the second bank of memory slots is structured to space the second memory boards by a second pitch, the second pitch different from the first pitch.
Example 7 includes any preceding clause(s) of any one or more of examples 1-6, wherein the second pitch is greater than from the first pitch.
Example 8 includes any preceding clause(s) of any one or more of examples 1-7, wherein the first bank of memory slots is positioned relative to the second bank of memory slots so that the first memory boards are to be upstream of the second memory boards along a flow path of a cooling fluid that is to pass across both the first memory boards and the second memory boards, the first and second pitches to cause a first cooling capacity of the cooling fluid across the first memory boards to be within a threshold of a second cooling capacity of the cooling fluid across the second memory boards, the threshold less than or equal to 2 watts.
Example 9 includes any preceding clause(s) of any one or more of examples 1-8, wherein the first bank of memory slots has a first width, and the second bank of memory has a second width, the second width different from the first width.
Example 10 includes any preceding clause(s) of any one or more of examples 1-9, wherein the second width is greater than the first width.
Example 11 includes any preceding clause(s) of any one or more of examples 1-10, wherein the first bank of memory slots includes a first number of memory slots, and the second bank of memory slots includes a second number of memory slots, the second number different from the first number.
Example 12 includes any preceding clause(s) of any one or more of examples 1-11, wherein the first memory boards have a first capacity and the second memory boards have a second capacity, the second capacity different from the first capacity.
Example 13 includes any preceding clause(s) of any one or more of examples 1-12, wherein the first memory boards are to operate at a same speed as the second memory boards.
Example 14 includes an apparatus comprising a motherboard for a server, a first memory bank to receive a first number of dual in-line memory modules (DIMMs), the first memory bank having a first elongate length, and a second memory bank to receive a second number of DIMMs, the second memory bank having a second elongate length, the first and second memory banks positioned end-to-end on the motherboard.
Example 15 includes any preceding clause(s) of example 14, wherein the motherboard includes a front end to be adjacent a fan that is to blow air across the motherboard, the first and second memory banks positioned end-to-end along a line that is to be substantially parallel to a flow direction of the air.
Example 16 includes any preceding clause(s) of any one or more of examples 14-15, wherein the first memory bank has a first width transverse to the first elongate length, and the second memory bank has a second width transverse to the second elongate length, the second width different from the first width while the first number is equal to the second number.
Example 17 includes any preceding clause(s) of any one or more of examples 14-16, wherein the first memory bank is closer to the front end than the second memory bank is to the front end, the first number of DIMMs to have a higher capacity than the second number of DIMMs.
Example 18 includes an apparatus comprising a first row of multiple memory banks of dual in-line memory module (DIMM) slots on a printed circuit board, the first row extending between lateral edges of the printed circuit board, a second row of multiple memory banks of DIMM slots to receive second DIMMs on the printed circuit board, the second row extending between the lateral edges of the printed circuit board, the first row closer to a front edge of the printed circuit board than the second row is to the front edge of the printed circuit board, and a processor socket on the printed circuit board, a first memory bank in the first row electrically coupled to the processor socket via the printed circuit board, a second memory bank in the second row electrically coupled to the processor socket via the printed circuit board.
Example 19 includes any preceding clause(s) of example 18, wherein the first memory bank is to hold first DIMMs a first pitch apart, and the second memory bank is to hold second DIMMs a second pitch apart, the second pitch greater than the first pitch.
Example 20 includes any preceding clause(s) of any one or more of examples 18-19, wherein the first memory bank is to hold first DIMMs having a first memory capacity, and the second memory bank is to hold second DIMMs having a second memory capacity, the first memory capacity greater than the second memory capacity.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. An apparatus comprising:
a circuit board including a first end, a second end opposite the first end, a first lateral edge, and a second lateral edge opposite the first lateral edge;
a first bank of memory slots to extend between the first and second ends of the circuit board, the first bank of memory slots a first distance from the first end, the first bank of memory slots to receive first memory boards; and
a second bank of memory slots to extend between the first and second ends of the circuit board, the second bank of memory slots a second distance from the first end, the second bank of memory slots to receive second memory boards, the second distance greater than the first distance.

2. The apparatus of claim 1, wherein the first and second banks of memory slots are in longitudinal alignment along a line extending between the first and second ends of the circuit board, the first bank of memory slots between the first end of the circuit board and the second bank of memory slots.

3. The apparatus of any one of claims 1-2, including a socket to receive a processor chip, the socket electrically coupled to both the first and second banks of memory slots via the circuit board, both the first and second banks of memory slots closer to the first lateral edge of the circuit board than the socket is to the first lateral edge of the circuit board.

4. The apparatus of claim 3, including:
a third bank of memory slots electrically coupled to the socket, the third bank of memory slots the first distance from the first end of the circuit board, the socket between the first and third banks of memory slots; and
a fourth bank of memory slots electrically coupled to the socket, the fourth bank of memory slots the second distance from the first end of the circuit board, the socket between the first and third banks of memory slots.

5. The apparatus of any one of claims 3-4, wherein the socket is a first socket, the apparatus including:
a second socket to receive a second processor chip; and
additional banks of memory slots electrically coupled to the second socket.

6. The apparatus of any one of claims 1-5, wherein the first bank of memory slots is structured to space the first memory boards by a first pitch and the second bank of memory slots is structured to space the second memory boards by a second pitch, the second pitch different from the first pitch.

7. The apparatus of claim 6, wherein the second pitch is greater than the first pitch.

8. The apparatus of any one of claims 6-7, wherein the first bank of memory slots is positioned relative to the second bank of memory slots so that the first memory boards are to be upstream of the second memory boards along a flow path of a cooling fluid that is to pass across both the first memory boards and the second memory boards, the first and second pitches to cause a first cooling capacity of the cooling fluid across the first memory boards to be within a threshold of a second cooling capacity of the cooling fluid across the second memory boards, the threshold less than or equal to 2 watts.

9. The apparatus of any one of claims 1-8, wherein the first bank of memory slots has a first width, and the second bank of memory has a second width, the second width different from the first width.

10. The apparatus of claim 9, wherein the second width is greater than the first width.

11. The apparatus of any one of claims 1-10, wherein the first bank of memory slots includes a first number of memory slots, and the second bank of memory slots includes a second number of memory slots, the second number different from the first number.

12. The apparatus of any one of claims 1-12, wherein the first memory boards have a first capacity and the second memory boards have a second capacity, the second capacity different from the first capacity.

13. The apparatus of claim 12, wherein the first memory boards are to operate at a same speed as the second memory boards.

14. The apparatus of claim 14, wherein the first end of the circuit board is to be adjacent a fan that is to blow air across the circuit board, the first and second banks of memory slots positioned end-to-end along a line that is to be substantially parallel to a flow direction of the air.
